**Europäisches Patentamt**

**European Patent Office**

**Office européen des brevets**

(19)

(11) **EP 1 117 091 A2**

(12) ## EUROPEAN PATENT APPLICATION

(43) Date of publication:
**18.07.2001 Bulletin 2001/29**

(51) Int Cl.⁷: **G11B 5/39**, H01L 43/08, G01R 33/09

(21) Application number: **01100259.9**

(22) Date of filing: **03.01.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **17.01.2000 JP 2000010330**

(71) Applicant: **SONY CORPORATION**
**Tokyo (JP)**

(72) Inventor: **Shoji, Mitsuharu, Sony Corporation**
**Tokyo (JP)**

(74) Representative: **MÜLLER & HOFFMANN**
**Patentanwälte**
**Innere Wiener Strasse 17**
**81667 München (DE)**

(54) **Magneto-resistive element production method**

(57)    When etching an MR thin film, a resist layer is formed into a shape having an under cut or an inverse taper shape. Moreover, when forming an electrode layer, an incident angle of sputter particles is adjusted. This enables to successively form a pair of bias layers and a pair of electrode layers with a single lift-off.

**FIG.10**

EP 1 117 091 A2

## Description

Background of the Invention

Field of the Invention

The present invention relates to a method for producing a magneto-resistive element for reading a signal recording on a magnetic recording medium utilizing the magneto-resistance effect.

Description of the Prior Art

Conventionally, a magneto-resistive type magnetic head (hereinafter, referred to as an MR head) for reading a signal recorded on a magnetic recording medium utilizing a magneto-resistance effect of a magneto-resistive element (hereinafter, referred to as an MR element) has been wide spread.

The MR element is a type of a resistive element which changes electric resistance according to a change of an external magnetic field. The MR head reads a magnetic signal recorded on a magnetic recording medium by utilizing the fact that the MR element changes its electric resistance according to a signal magnetic field from the magnetic recording medium.

Recently, a small-size and large-capacity magnetic recording medium has been desired. To cope with this, there is a tendency to increase the recording density of the magnetic recording medium by using a technique, for example, to reduce the recording track width.

On the other hand, in order to prevent lowering of a signal output due to reduction in the track width of the magnetic recording medium, a great attention is now paid on an MR element utilizing the giant magneto-resistivity (GMR) to replace the MR element utilizing anisotropic magneto-resistivity (AMR).

As a film configuration having the giant magneto-resistivity, for example, there has been suggested a spin bulb film. The spin bulb film includes a first ferromagnetic film (free layer), a non-magnetic film, a second ferromagnetic film (pin layer), and an antiferromagnetic film which are successively layered. In the spin bulb film, the pin layer has a magnetization direction fixed by a bias magnetic field from the antiferromagnetic film, and the free layer has a magnetization direction which is rotated according to a signal magnetic field. Here, a magnetic signal is read according to a change of the electric resistance.

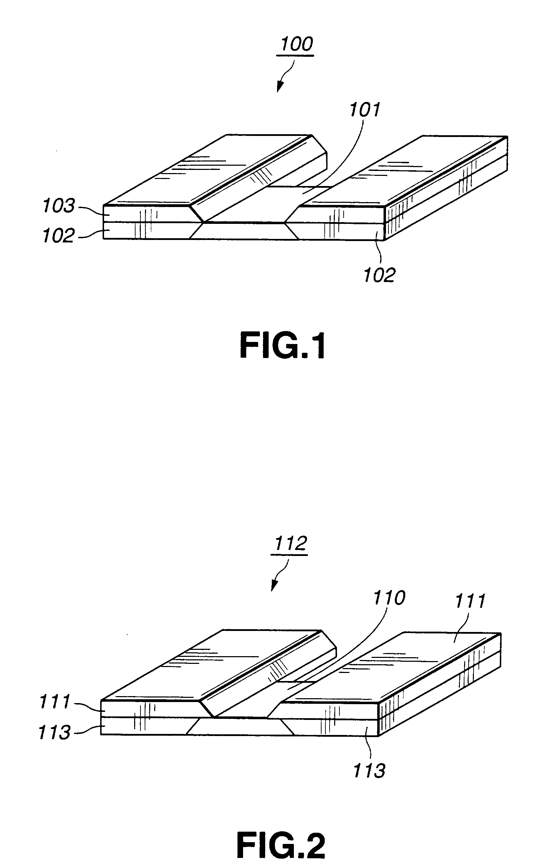

In an MR head using this spin bulb film as the MR thin film, the MR element 100, in general, has an abutment junction structure as shown in Fig. 1. Here, the free layer in the MR thin film 101 is subjected to a bias magnetic field by the bias layer 102. This suppresses generation of a domain wall in the MR thin film 101, which in turn suppresses generation of the Barkhausen noise, thereby enabling to obtain a stable reproduction output of the MR head.

Here, if the bias magnetic field applied to the MR thin film 101 by the bias layer 102 is insufficient, a domain wall moves inside the MR thin film 101, causing the Barkhausen noise, and it becomes impossible to obtain a sufficient S/N.

In order to obtain a sufficient bias magnetic field, the bias layer 102 should be formed with a sufficient thickness. However, increase of the thickness increases the bias magnetic field applied to the entire MR thin film 101. Accordingly, the effective track width is reduced. To correct this, the MR thin film 101 should have a large width. However, when the MR thin film 101 has a large width, the entire resistance of the MR element 100 is increased.

Moreover, when the MR head has the abutment junction structure, there is a tendency that the contact resistance at the junction between the MR thin film 101 an the bias layer 102 is increased. Moreover, the aforementioned contact resistance irregularities become prominent.

In order to solve these problems, there has been suggested an electrode overlap structure as shown in Fig. 2. In this electrode overlap structure, an electrode layer 111 overlaps on the MR thin film 110.

When the MR element 112 has the electrode overlap structure, sense current is supplied from the overlap portion of the electrode layer 111 to the MR thin film 110 without passing through the bias layer 113. Accordingly, there is almost no affect from the contact resistance at the junction between the MR thin film 110 and the bias layer 113.

This enables to significantly reduce the resistance value in the MR head and increase durability against electro-migration and electrostatic discharge. Moreover, the effective track width is matched with distance between a pair of electrode layers 111.

However, when producing the MR element 112 having the electrode overlap structure as shown in Fig. 2, it is necessary to perform the lift-off twice, complicating the production procedure.

More specifically, firstly, as shown in Fig. 3, a first resist layer 114 is formed on the MR thin film 110. Next, as shown in fig. 4, the MR thin film 110 is etched. Next, as shown in Fig. 5, a bias layer 113 is formed. Next, as shown in Fig. 6, the first resist layer 114 is lifted-off using an organic solvent. Next, as shown in Fig. 7, a second resist layer 115 is formed. Next, as shown in Fig. 8, an electrode layer 111 is formed. Next, as shown in Fig. 9, the second resist layer 115 is lifted-off using an organic solvent.

As has been described above, the MR element 112 having the electrode overlap structure is produced by a complicated production procedure and a difference is easily caused in the overlap amounts of the pair of electrode layers 111 for the MR thin film 110. Accordingly, there arises a problem that the sensitivity distribution of the MR thin film 110 becomes asymmetric in the track width direction.

One solution to prevent the asymmetric sensitivity distribution of the MR thin film 110 due to the difference in the overlap amounts of the pair of the electrode layers 111 is to increase the overlap amounts of the electrode layer 111 with respect to the MR thin film 110.

However, in this case, a non-magneto-sensitive portion at both ends of the MR thin film 110 is increased. This results in that the signal magnetic field detecting portion in the MR thin film 110 is located at the center of the MR thin film 110, which increases a distance from the bias layer 113. Moreover, this requires increase of the width of the MR thin film 110 formed on the substrate, which increases a distance between the pair of bias layers 113.

These facts bring about a problem that the bias magnetic field applied to the MR thin film 110 by the bias layer 113 is insufficient and the reproduction operation of the MR element 112 becomes unstable.

Summary of the Invention

It is therefore an object of the present invention to provide a method for producing a magneto-resistive element including a pair of electrode layers having an identical overlap amount with respect to a magneto-resistive thin film and a sufficient bias magnetic field is applied to the MR thin film.

The magnetoresistive element production method according to the present invention produces a magnetoreistive element having an electrode-overlap structure by a thin film formation procedure including a magnetoresistive film formation step, a bias layer formation step, and an electrode layer formation step.

In the magnetoresistive film formation step, a magnetoresistive film is formed with a predetermined width. In the bias layer formation step, a resist layer of a shape having an under cut or of an inverse taper shape is formed and a pair of bias layers is formed at both ends thereof using a hard magnetic material. In the electrode layer formation step, a pair of electrode layers is formed on the bias layers by sputtering a conductive metal material using the resist layer as a mask in such a manner that the electrodes overlap with the magnetoresistive film.

Accordingly, a plurality of steps can be simplified into one step, thereby improving the productivity of the magnetoreistive element. Moreover, this enables to obtain an identical overlap amount of the pair of electrode layers for the MR thin film as well as adjust the overlap amount with a high accuracy.

Brief Description of the Drawings

Fig. 1 is a perspective view of an MR element having the conventional abutment junction structure.

Fig. 2 is a perspective view of an MR element having the conventional electrode overlap structure.

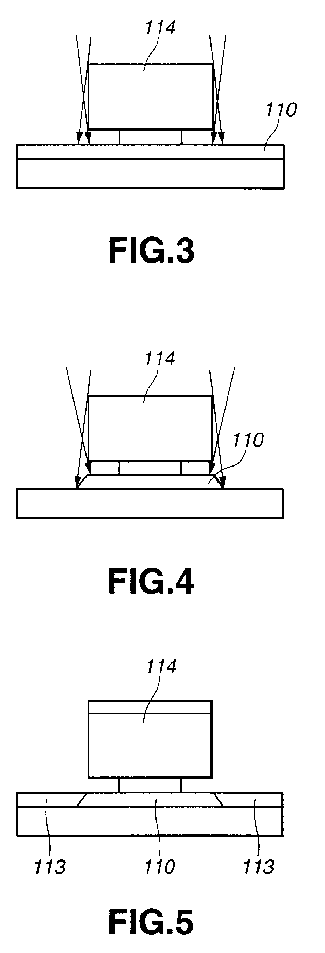

Fig. 3 explains a production procedure for producing the MR element having the conventional electrode overlap structure and provides a cross sectional view in which a first resist layer is formed on an MR thin film layer.

Fig. 4 explains the production procedure for producing the MR element having the conventional electrode overlap structure and provides a cross sectional view in which the MR thin film layer is etched.

Fig. 5 explains the production procedure for producing the MR element having the conventional electrode overlap structure and provides a cross sectional view in which a hard magnetic layer is formed.

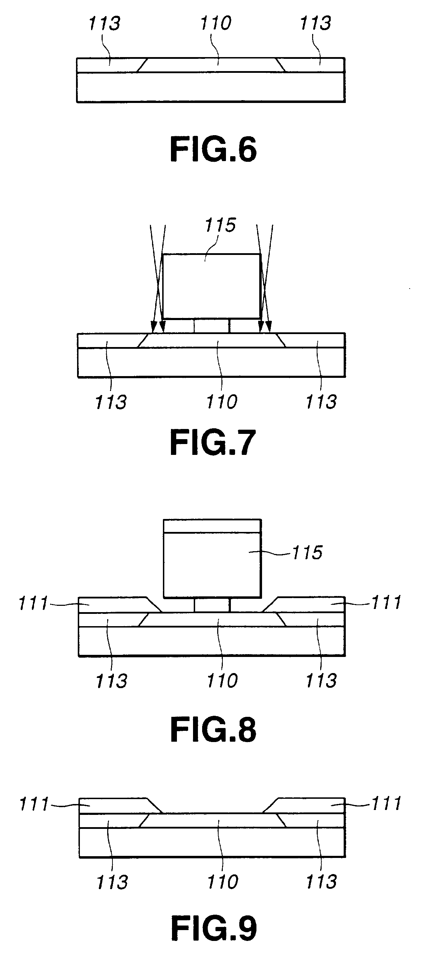

Fig. 6 explains the production procedure for producing the MR element having the conventional electrode overlap structure and provides a cross sectional view in which the first resist layer has been removed.

Fig. 7 explains the production procedure for producing the MR element having the conventional electrode overlap structure and provides a cross sectional view in which a second resist layer is formed on the MR thin film.

Fig. 8 explains the production procedure for producing the MR element having the conventional electrode overlap structure and provides a cross sectional view in which a conductive metal layer is formed.

Fig. 9 explains the production procedure for producing the MR element having the conventional electrode overlap structure and provides a cross sectional view in which the second resist layer has been removed.

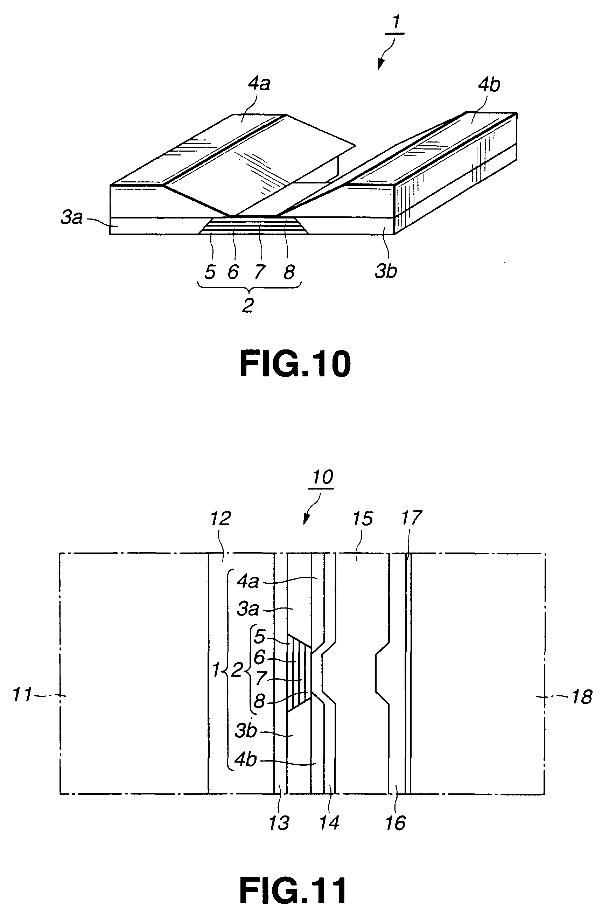

Fig. 10 is a perspective view of an MR element produced according to the present invention.

Fig. 11 is a plan view of a sliding surface of an MR head prepared by using the aforementioned MR element.

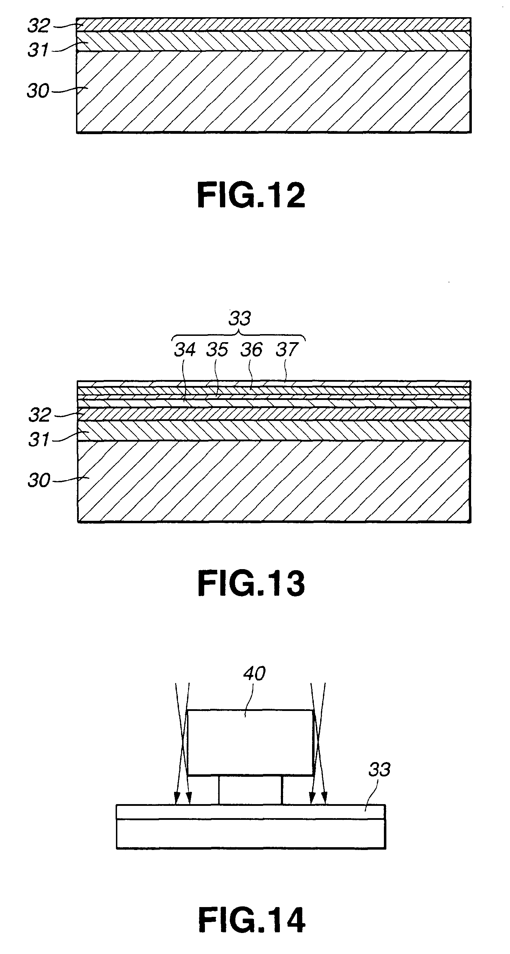

Fig. 12 explains a production procedure of the MR element and provides a cross sectional view in which a first soft magnetic layer and a first non-magnetic and non-conductive layer are formed on a substrate.

Fig. 13 explains the production procedure of the MR element and provides a cross sectional view in which an MR thin film layer is formed.

Fig. 14 explains the production procedure of the MR element and provides a cross sectional view in which a resist layer is formed on the MR thin film.

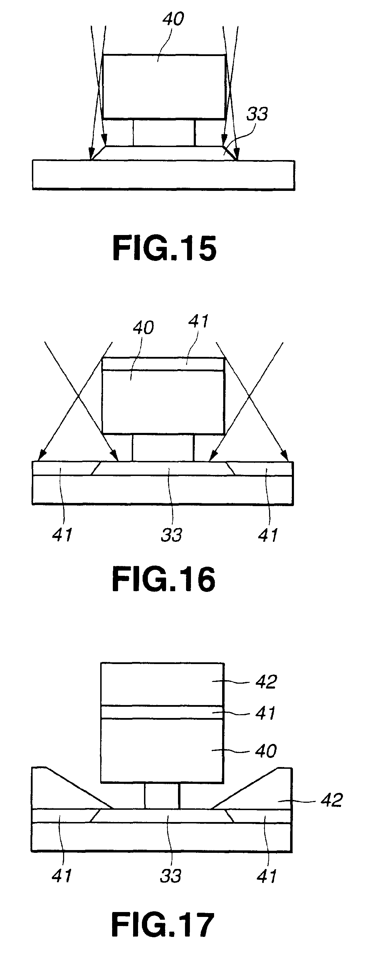

Fig. 15 explains the production procedure of the MR element and provides a cross sectional view in which the MR thin film is etched.

Fig. 16 explains the production procedure of the MR element and provides a cross sectional view in which a hard magnetic layer is formed.

Fig. 17 explains the production procedure of the MR element and provides a cross sectional view in which a conductive metal layer is formed.

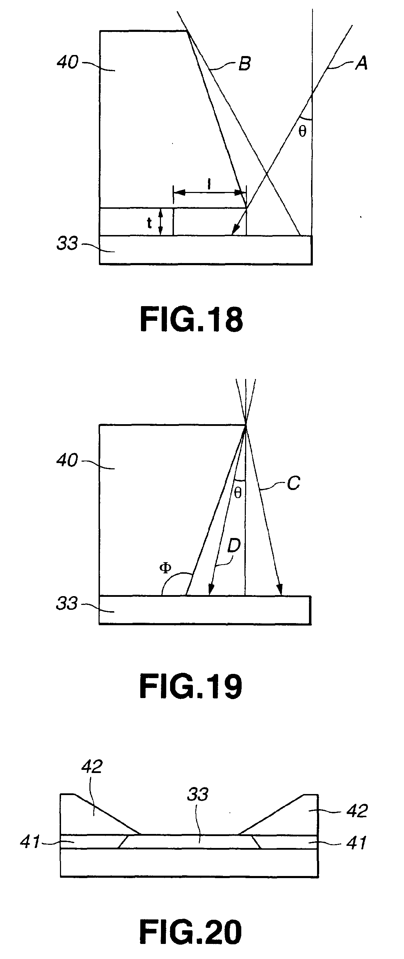

Fig. 18 explains a relationship between a sputter particle incident angle θ, an undercut amount I, and an undercut portion t when forming an electrode layer by a resist layer having an undercut shape.

Fig. 19 explains a relationship between a sputter particle incident angle θ and a resist angle φ when forming an electrode layer by a resist layer having an inverse-tapered shape.

Fig. 20 explains a production procedure of the MR element and provides a cross sectional view in which the resist layer has been removed.

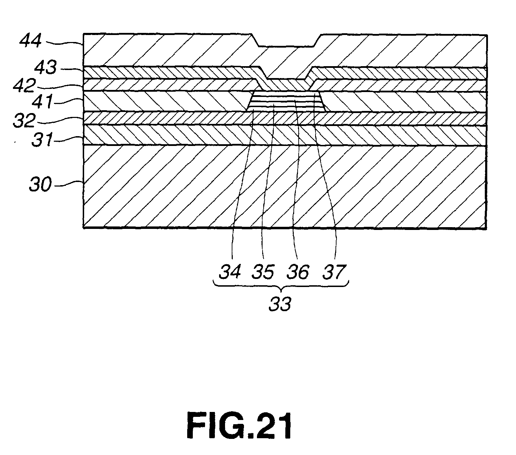

Fig. 21 explains the production procedure of the MR element and provides a cross sectional view in which a second non-magnetic and non-conductive layer and a second soft magnetic layer are formed.

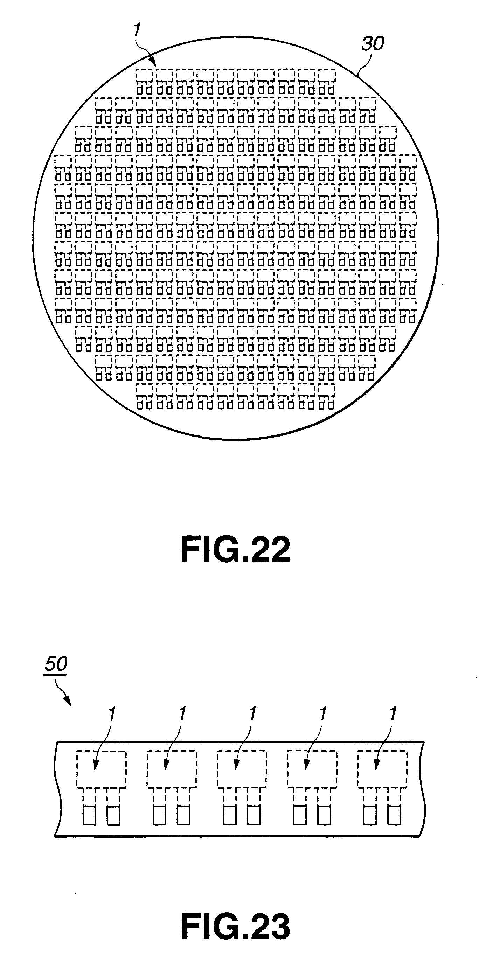

Fig. 22 explains the production procedure of the MR element and provides a plan view of a first substrate on which a plenty of MR elements have been formed.

Fig. 23 explains the production procedure of the MR element and provides a plan view of a magnetic head block cut in such a way that a plenty of MR elements are arranged in the lateral direction.

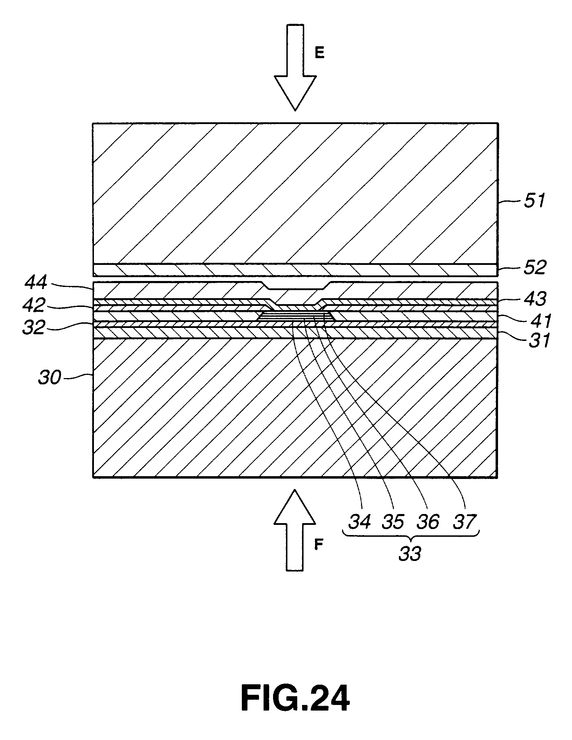

Fig. 24 explains the production procedure of the MR element and provides a cross sectional view of a second substrate adhered.

Detailed Description of Preferred Embodiments

Description will now be directed to an embodiment of the present invention with reference to the attached drawings. Hereinafter, an explanation will be given on a magneto-resistive element 1 (hereinafter, referred to as the MR element 1) as shown in Fig. 10.

It should be noted that the drawings used in the explanation below contain parts which are shown in different scales so that important parts can clearly be shown. Moreover, while the explanation will be given on film configurations and materials constituting the MR element 1, the present invention is not to be limited to the MR element 1 explained below as an example and it is possible to select the thin film configurations and materials according to a desired performance and purpose.

The MR element 1 includes a magneto-resistive thin film 2 (hereinafter, referred to as an MR thin film 2) formed on a substrate and includes, on both end portions in its longitudinal direction, bias layers 3a and 3b (hereinafter, referred to as the bias layer 3) and electrode layers 4a and 4b (hereinafter, referred to as the electrode layer 4).

The MR thin film 2 includes a first ferromagnetic film 5 (free layer), a non-magnetic film 6, a second ferromagnetic film 7 (fixed layer), and an antiferromagnetic film 8 which are successively layered in this order from the side of the substrate.

The first ferromagnetic film 5 is formed from a ferromagnetic material. The ferromagnetic material may be, for example, NiFe, CoFe, and the like. The first ferromagnetic film 5 is a so-called magneto-sensitive portion for detecting a weak signal magnetic field from a magnetic recording medium.

The non-magnetic film 6 is made from a non-magnetic material. The non-magnetic material may be, for example, Au, Ag, Cu, and the like. The non-magnetic film 6 is formed so as to generate a magnetostatic coupling between the first ferromagnetic film 5 and the second ferromagnetic film 7. Thus, the giant magneto-resistivity appears in the MR thin film 2.

The second ferromagnetic film 7 is formed from a ferromagnetic material. The ferromagnetic material may be, for example, NiFe, CoFe, Co, and the like. The second ferromagnetic film 7 is a portion where the magnetization direction is fixed.

The antiferromagnetic film 8 is formed from an antiferromagnetic material. The antiferromagnetic material may be, for example, IrMn, FeMn, NiMn, RhMn, PtMn, CoPtMn, and the like. The antiferromagnetic film 8 is a portion in exchange coupling with the second ferromagnetic film 7 so as to fix the magnetization direction of the second ferromagnetic film 7.

It should be noted that here the MR thin film 2 is formed by a spin bulb film but the MR thin film 2 is not to be limited to the spin bulb film. The MR thin film 2 may be formed by various conventionally known film formation methods such as the so-called AMR and GMR.

The MR thin film 2 is a portion for detecting a signal magnetic field from a magnetic recording medium and reproducing a magnetic record. Moreover, the MR thin film 2 is arranged in an MR head, which will be detailed later, in such a manner that its longitudinal direction is in parallel to a sliding surface and sense current is supplied in a direction parallel to the sliding surface.

The pair of bias layers 3a and 3b is made from a hard magnetic material and arranged at both ends of the MR thin film 2 in the longitudinal direction. The pair of bias layers 3a and 3b has a function to apply a bias magnetic field to the MR thin film 2 and to form a single magnetic domain in the MR thin film 2. Moreover, the bias layers 3a and 3b are connected magnetically and electrically to the both ends of the MR thin film 2, respectively. It should be noted that the pair of bias layer 3a and 3b will be referred to simply as the bias layer 3 in the explanation below.

The electrode layers 4a and 4b are formed in the form of a thin film from a metal material having electro-conductivity and a low resistance. The electrode layers 4a and 4b are preferably made from, for example, Cr, Ta, and the like. The electrode layers 4a and 4b are respectively connected electrically to the both ends of the MR thin film 2 and supply a sense current to the MR thin film 2.

The electrode layers 4a and 4b are formed so as to be overlapped on the MR thin film 2, so that a distance between the electrode layer 4a and the electrode layer 4b is equal to an effective track width. Moreover, this makes difficult occurrence of electro-migration and electrostatic discharge. It should be noted that in the explanation below, the electrode layers 4a and 4b will be referred to simply as the electrode layer 4.

Next, explanation will be given on a production method of the aforementioned MR element 1. Here, a specific explanation will be given on a production method of the aforementioned MR element 1 which is applied to the MR head 10 as one of the magnetic devices. However, the present invention is not to be limited to the example below. For example, a recording magnetic head for recording a magnetic signal to a magnetic recording medium may be formed as a unitary block with the MR head 10.

Moreover, in the drawings used for the explanation below, some members are shown in different scales so that important parts can clearly be shown.

Here, explanation will be given on the configuration of the MR head 10. As shown in Fig. 11, the MR head 10 includes a first substrate 11, on which a lower magnetic shield layer 12 and a lower gap layer 13 are successively formed in this order. On the lower gap layer 13, the MR element 1 is formed.

On the MR element 1, an upper gap layer 14 and an upper magnetic shield layer 15 are successively formed. On the upper gap layer 14 and the upper magnetic shield layer 15, a protection film 16 is formed. On the protection film 16, a second substrate 18 is adhered via an adhesive layer 17.

The first substrate 11 and the second substrate 18 are formed from a high-hardness non-magnetic material. The material may be, for example, ceramic, alumina-titanium-carbide (AlTiC), and the like. Moreover, the first substrate 11 and the second substrate 18 have one side serving as a tape sliding surface where a tape-shaped recording medium slides. This tape sliding surface is defined as a curved surface having a predetermined curvature.

The lower magnetic shield layer 12 and the upper magnetic shield layer 15 are formed from a soft magnetic material. The soft magnetic material may be, for example, Sendust (Fe-Al-Si alloy), FeTa, Co-system amorphous material, and the like.

The lower magnetic shield layer 12 and the upper magnetic shield layer 15 function so that signal magnetic fields from the magnetic recording medium other than those to be reproduced will not be pulled into the MR thin film 5. That is, signal magnetic fields other than those to be reproduced are led by the lower magnetic shield layer 12 and the upper magnetic shield layer 15, so that only the signal magnetic field to be reproduced is led to the MR thin film 2. This improves the high-frequency characteristic and the reading resolution of the MR thin film 2.

The lower gap layer 13 and the upper gap layer 14 are formed from a non-magnetic non-conductive material. The lower gap layer 13 and the upper gap layer 14 are preferably formed from, for example, $Al_2O_3$, considering insulation and wear resistance. Presence of the lower gap layer 13 and the upper gap layer 14 assures insulation in the MR thin film 2.

The protection layer 16 is formed from a non-magnetic non-conductive material. The protection layer 16 disconnects the MR element 1 from the exterior electrically and magnetically.

The adhesive layer 17 is formed using an adhesive agent for adhering the second substrate 18. The adhesive agent used for this may be, for example, an epoxy-system adhesive.

When producing the aforementioned MR head 10, firstly, as shown in Fig. 12, on a first substrate material 30 to become as the first substrate 11, a first soft magnetic metal layer 31 to become the lower magnetic shield layer 3 and a first non-magnetic and non-conductive layer 32 to become the lower gap layer 4 are formed by sputtering or the like.

Next, as shown in Fig. 13, on the first non-magnetic and non-conductive layer 32, an MR thin film layer 33 to constitute the MR thin film 2 is formed by the sputtering method or the like. More specifically, the MR thin film layer 33 is formed, for example, by successively forming a first ferromagnetic layer 34 to become the first ferromagnetic film 5, a non-magnetic layer 35 to become the non-magnetic film 6, a second ferromagnetic layer 36 to become the second ferromagnetic film 7, and an anti-ferromagnetic layer 37 to become the anti-ferromagnetic film 8.

Next, as shown in Fig. 14, on the MR thin film layer 33, a resist layer 40 is formed. Here, the resist layer 40 is formed, for example, by a two-layered resist method using polyimide to have a shape having an under cut. However, it is also possible to use a single-layered resist method to form the shape having an under cut or to use the single-layered resist method to form an inverse tapered shape.

By forming the resist layer 40 with the shape having an under cut or the inverse tapered shape, the bias layer 3 and the electrode layer 4 can be formed at once by performing lift-off only once instead of twice.

Next, as shown in Fig. 15, the MR thin film layer 33 is etched. Here, it is preferable to perform the etching by a method such as ion milling having a high orientation.

Next, as shown in Fig. 16, a hard magnetic layer 41 to become the bias layer 3 is formed by the sputtering method or the like on both end portions of the MR thin film layer 33 in the longitudinal direction. Here, the hard magnetic layer 41 should be formed with a high accuracy at the portion of the MR thin film layer 33 which has been removed by etching. Accordingly, it is preferable to use a sputtering method using an apparatus for a high orientation of sputter particles such as the ion beam sputtering method and the collimate sputtering method.

Next, as shown in Fig. 17, a conductive metal layer 42 to become the electrode layer 4 is formed. This conductive metal layer 42 may be formed by one of the following two methods.

The first method is to form the conductive metal layer 42 by the sputtering method using an apparatus for high orientation of sputter particles. In this case, the sputter incident angle θ is a value satisfying Equation 3 or Equation 4 given later, so that the conductive metal layer 42 is formed to overlap on the MR thin film layer 33.

The second method is to form the conductive metal layer 42 by using the film formation apparatus used for forming the hard magnetic layer 41 or the film formation method of the hard magnetic layer 41 to deteriorate the orientation, thereby dispersing sputter particles. In this case, the dispersion of the sputter particles enables to introduce sputter particles into the bottom portion of the resist layer 40 having the under cut. Thus, the conductive metal layer 42 is formed to overlap on the MR thin film layer 33.

It should be noted that when the resist layer 40 has been formed with a shape having an under cut by the two-layered resist method or the single-layered resist method, the incident angle θ of the sputter particles can be determined by Equation 3 given below.

$$I > t \times \tan \theta \qquad \text{Equation 3}$$

wherein I represents an under cut amount in the resist layer 40 as shown in Fig. 18, and t represents a size of the under cut portion in the resist layer 40. It should be noted that the under cut portion means a length from the lower surface of the resist layer 40 to the upper surface of the under cut.

When this relationship is satisfied, the conductive metal layer 42 is formed to overlap over the MR thin film layer 33. Unless this relationship is satisfied, it become impossible to form the conductive metal layer 42 with a predetermined shape. It should be noted that the arrow A and arrow B in Fig. 18 show incident directions of sputter particles.

Moreover, when the resist layer 40 has an inverse tapered shape, the incident angle θ of the sputter particles can be determined by Equation 4 given below.

$$\phi > \theta + 90° \qquad \text{Equation 4}$$

wherein φ represents a taper angle of the resist layer 40. When this relationship is satisfied, the conductive metal layer 42 is formed so as to overlap over the MR thin film layer 33. Unless this relationship is satisfied, it becomes impossible to form the conductive metal layer 42 with a predetermined shape. It should noted that the arrows C and D in Fig. 19 show incident directions of sputter particles.

Here, the conductive metal layer 42 was formed while changing the incident angle θ of the sputter particles was change to check the relationship between the incident angle θ of the sputter particles and the overlap amount of the conductive metal layer 42 over the MR thin film layer 33.

Firstly, the relationship between the incident angle θ of the sputter particles and the overlap amount of the conductive metal layer 42 over the MR thin film layer 33 was checked when forming the resist layer 40 by the two-layered resist method so as to have a shape having an under cut. The result is shown in Table 1.

It should noted that the resist layer 40 had an upper resist having a thickness of 1 μm, an under cut portion having a size of 0.2 μm, and an under cut amount I of 0.3 μm. This enables to prevent generation of burrs when lifting-off the resist layer 40. Moreover, the angle for formation of the hard magnetic layer 41 was set to 5°.

Table 1

| Incident angle (deg) | Overlap amount (μm) |
|---|---|
| 10 | 0.05 |
| 20 | 0.09 |
| 30 | 0.13 |
| 40 | 0.18 |
| 50 | 0.26 |

Moreover, the relationship between the incident angle θ of the sputter particles and the overlap amount of the conductive metal layer 42 over the MR thin film layer 33 was checked for the resist layer 40 having an inverse taper formed by the single-layered resist method. The result is shown in Table 2.

It should be noted that the resist layer 40 had a size of 1 μm and the taper angle φ was set to 130°. This enabled to prevent generation of burrs when lifting-off the resist layer 40. Moreover, the angle when forming the hard magnetic layer 41 was set to 5°.

[Table 2]

| Incident angle (deg) | Overlap amount (μm) |
|---|---|
| 5 | 0.02 |
| 10 | 0.11 |
| 15 | 0.2 |
| 20 | 0.3 |

As has been described above, it can be seen that the overlap amount of the conductive metal layer 42 over the MR thin film layer 33 can be adjusted by changing the incident angle θ of the sputter particles.

Moreover, the overlap amount of the conductive metal layer 42 over the MR thin film layer 33 is preferably in a range no less than 0.01 μm and not greater than 0.25 μm.

When the overlap amount is less than 0.01 μm; sense current flows via the bias layer 3 in the MR head 10 and accordingly, it becomes impossible to reduce the contact resistance between the MR thin film 2 and the electrode layer 4. Thus, it becomes impossible to lower the overall resistance value of the MR head 10.

Moreover, since it is impossible to cover the non-sensitive portion at the end portion of the MR thin film 2 in the MR head 10 with the electrode layer 4, the distance between the pair of electrode layers 4 does not match with the effective track width.

Moreover, when the overlap amount is equal to or more than 0.25 μm, a portion of the MR thin film 2 for detecting a signal magnetic field form the magnetic recording medium is reduced, disabling to obtain a sufficient effective track width. This deteriorates the reproduction sensitivity of the MR head 10.

Next, as shown in Fig. 20, the resist layer 40 is removed by using an organic solvent. It should be noted that in Fig. 14 to Fig. 20, the first substrate material 30, the first soft magnetic layer 31, and the first nonmagnetic and non-conductive layer 32 are not depicted.

As has been described above, by successively forming the hard magnetic layer 41 and the conductive metal layer 42 with a single lift-off, it is possible to simplify the process for forming the electrode layer 4 so as to overlap over the MR thin film 2, which improves the productivity.

Moreover, since it becomes possible to form the pair of electrode layers 4 with an identical overlap amount, there is no danger of asymmetric sensitivity distribution in the track width direction of the MR thin film 2. Thus, it becomes possible to provide the MR element 1 with a stable reproduction operation. Moreover, the reproduction using the MR head 10 prepared using the MR element 1 becomes stable.

Next, as shown in Fig. 21, on the MR thin film 33 and the conductive metal layer 42, a second nonmagnetic and non-conductive layer 43 to become the upper gap layer 14 and a second soft magnetic metal layer 44 to become the upper magnetic shield layer 15 are successively formed by sputtering or the like.

At this stage, a plurality of MR elements 1 are formed on the first substrate material 30 as shown in Fig. 22. This first substrate material 30 is cut into strip shapes in such a manner that the MR elements 1 are arranged in the lateral direction so as to form an MR head block 50 as shown in Fig. 23. Although Fig. 23 shows only 5 MR elements 1 in the MR head block 50 for simplicity, the number of the elements should be as great as possible if productivity is considered.

Next, this MR head block 50 is adhered via an adhesive 52 to a second substrate material 51 which has been made into a stripe shape. A pressure is applied in the direction indicated by the arrows E and F in Fig. 24 so as to obtain a unitary block. This second substrate material 51 finally becomes the second substrate 27. It should be noted that one of the MR elements 1 formed on the substrate 30 is enlarged in Fig. 12 to Fig. 21, and Fig. 24.

Next, a cylindrical polishing is performed to a surface of the MR head 10 which is to become the tape sliding surface and the surface is made into an arc shape. More specifically, the cylindrical polishing is performed until the front end of the MR thin film 2 is exposed to the tape sliding surface and the depth length of the MR thin film 2 becomes a predetermined length. It should be noted that the curve shape of the surface to become the tape sliding surface formed by this cylindrical polishing is not limited to a particular shape if it is appropriate according to the tape tension and the like.

Next, the magnetic head block 50 is divided into respective MR heads 10. Here, the magnetic head block 50 is divided not vertically but with an angle identical to the azimuth angle.

As is clear from the aforementioned, according to the production method of the MR element 1 according to the present invention, it is possible to simplify the step for forming the electrode layer 4 with an overlap for the MR thin film 2. This eliminates need of pattern matching of the electrode layer 4 through a plurality of steps. Thus, it becomes possible to obtain an accurate overlap amount of the electrode layer 4 over the MR thin film 2, thereby improving the productivity.

Moreover, this eliminates asymmetric sensitivity distribution in the track width direction in the MR thin film 2 because of different overlap amounts of the pair of electrode layers 4 for the MR thin film 2. Thus, it is possible to obtain a stable reproduction operation of the MR element 1. Moreover, the reproduction operation of the MR head 10 prepared using the MR element 1 becomes stable.

Moreover, when the resist layer 40 has a shape having an under cut, it is possible to adjust the overlap amount of the electrode layer 4 for the MR thin film 2 by changing the incident angle θ of sputter particles, the under cut amount I in the resist layer 40, and the size t of the under cut portion.

As is clear from the aforementioned, according to the production method of the magnetoresistive element according to the present invention, it is possible to simplify the procedure for forming the electrode layer to overlap with the magnetoresistive thin film, thereby improving the productivity.

Moreover, this eliminates asymmetric sensitivity distribution in the track width direction in the magnetoresistive thin film due to different overlap amounts of the pair of electrode layers for the magnetoresistive thin film. This enables to provide a magnetoresistive element having a stable reproduction operation.

**Claims**

1. A magnetoresistive element production method for producing a magnetoreistive element having an electrode-overlap structure by a thin film formation procedure comprising:

a magnetoresistive film formation step for forming a magnetoresistive film with a predetermined width on a substrate,
a bias layer formation step for forming a resist layer of a shape having an under cut or of an inverse taper shape and forming a pair of bias layers at both ends of the magnetoresistive film using a hard magnetic material, and
an electrode layer formation step for forming a pair of electrode layers on the bias layers by sputtering a conductive metal material using the resist layer as a mask in such a manner that the electrodes overlap with the magnetoresistive film.

2. The magnetoresistive element production method as claimed in Claim 1, wherein the electrode layer formation step is performed in such a manner that the electrode layers have an overlap amount for the magnetoresistive film in a range not smaller than 0,01 μm and not greater than 0.25 μm.

3. The magnetoresistive element production method as claimed in Claim 1, wherein the electrode formation step is performed in such a manner that an incident angle θ for sputtering the conductive metal material satisfies Equation 1 below

$$l > t \times \tan \theta \qquad \text{Equation 1}$$

wherein l is an under cut amount and t is a size of the under cut portion.

4. The magnetoresistive element production method as claimed in Claim 1, wherein the electrode formation step is performed in such a manner that an incident angle θ for sputtering the conductive metal material satisfies Equation 2 below

$$\phi > \theta + 90° \qquad \text{Equation 2}$$

wherein φ is a taper angle.

EP 1 117 091 A2

FIG.1

FIG.2

**FIG.3**

**FIG.4**

**FIG.5**

**FIG.6**

**FIG.7**

**FIG.8**

**FIG.9**

**FIG.10**

**FIG.11**

32
31

30

## FIG.12

33
34 35 36 37

32
31

30

## FIG.13

40

33

## FIG.14

**FIG.15**

**FIG.16**

**FIG.17**

**FIG.18**

**FIG.19**

**FIG.20**

44

43

42

41

32

31

30

34 35 36 37

33

# FIG.21

FIG.22

FIG.23

**FIG.24**